# EUROPÄISCHE PATENTANMELDUNG

(11) **EP 0 999 732 A2**
(43) Veröffentlichungstag der Anmeldung: **10.05.2000**
(21) Anmeldenummer: 99122139.1
(22) Anmeldetag: 05.11.1999
(51) Int. Cl.: H05K 7/14, H05K 5/00

(54) **Elektronisches Gerät mit einem Einbaugehäuse**

(30) Priorität: 07.11.1998 DE 29819944 U
(71) Anmelder: GOSSEN-METRAWATT Gesellschaft mit beschränkter Haftung, D-90471 Nürnberg (DE)
(72) Erfinder: Lottes, Hermann, 90768 Fürth (DE); Feldmann, Peter, 90461 Nürnburg (DE)
(74) Vertreter: Stippl, Hubert

(57) **Zusammenfassung**

Die Erfindung betrifft ein elektronisches Gerät 1 mit einem einbaugehäuse 2 zum Einsetzen in ein Wandelement, insbesondere eine Schalttafel, einen Schaltschrank oder dgl., wobei das Einbaugehäuse 2 aus einem seiten- und rückwandbildenden Gehäuserückteil 5 sowie einer Gehäusefront 6 besteht, in welcher Bedienungs- und/oder Anzeigeelemente angeordnet sind und die mit einer Abdeckscheibe versehen ist, wobei parallel und mit geringem Abstand hinter der Gehäusefront 6 oder der Abdeckscheibc ein Paket aus mindestens zwei über Abstandselemente 11 als Sandwich miteinander verbundenen Leiterplatten 12, 13 befestigt ist, die den lichten Querschnitt des Gehäuserückteils 5 ausfüllen und als Träger für die Bedienungs- 7 und Anzeigeelemente 8 und elektronische Bauteile dienen.

## Beschreibung

Die Erfindung/Neuerung betrifft ein elektronisches Gerät mit einem Einbaugehäuse zum Einsetzen in einem Wandelement. Wenn von einem Wandelement gesprochen wird, so sind insbesondere Schalttafeln, Schaltschränke, Fronten von großen elektrischen Gehäusen oder dgl. gemeint. Das Einbaugehäuse des elektrischen Gerätes besteht aus einem seiten- und rückwandbildenden Gehäuserückteil sowie einer Gehäusefront. In der Gehäusefront sind Bedienungs- und/oder Anzeigeelemente angeordnet. Die Gehäusefront ist ferner mit einer Abdeckscheibe versehen, um die Anzeigeelemente zu überdecken.

Ist die Abdeckscheibe elastisch ausgebildet, so können durch sie hindurch auch Bedienungselemente betätigt werden. Es ist aber auch möglich, die Abdeckscheibe mit Ausnehmungen für die Bedienungselemente zu versehen

Als Stand der Technik ist es bekannt, die Gehäusefront mit Abdeckscheibe und Anzeigeeinrichtung als gesondertes Bauteil vorzusehen. Platinen, die mit elektrischen/elektronischen Bauteilen bestückt sind, werden dann gesondert in einem solchen Gehäuse untergebracht, verschaltet und befestigt

Der Erfindung/Neuerung liegt die Aufgabe zugrunde, ein elektronisches Gerät mit den Merkmalen des Oberbegriffs des Anspruchs 1 derart weiterzubilden, daß Aufbau und Montage eines solchen Gerätes vereinfacht sind

Diese Aufgabe wird dadurch gelöst, daß parallel und mit geringem Abstand hinter der Gehäusefront ein Paket aus mindestens zwei über Abstandselemente als Sandwich miteinander zu einer baulichen Einheit verbundenen Leitplatten befestigt ist, die den lichten Querschnitt des Gehäuserückteils ausfüllen und als Träger für die Bedienungs-/Anzeigeelemente und die elektronischen Bauteile dienen.

Durch die beiden miteinander verbundenen Leiterplatten können zweischichtig auf der der Frontseite zugewandten Platte Bedienungs- und Anzeigeelemente und auf der Rückseite mehr oder weniger vollflächig weitere elektrische Bauteile aufgebracht werden. Trotzdem handelt es sich bei dem Sandwich um ein einheitlich vormontierbares, handhabbares und gegebenenfalls auch austauschbares Bauteil, das einfach anzuschließen und auch in dem Gehäuse zu befestigen ist.

Vorteilhafterweise liegen die Leiterplatten deckungsgleich übereinander und sind an ihren Rändern mit miteinander fluchtenden Ausnehmungen versehen, in welchen die Abstandselemente befestigt sind. Die Abstandselemente können hülsenartig ausgebildet sein und einen runden Querschnitt aufweisen. Das Paket aus Leiterplatten kann zur Vereinfachung der Montage von der Frontseite des Gehäuserückteils in dieses einschiebbar sein, wobei Führungszapfen im Gehäuse vorgesehen sind, die in die Hülsen eingreifen, wodurch eine gute Fixierung und Halterung der Leiterplatten in dem Gehäuse gewährleistet ist. Das Leiterplattenpaket kann in Endmontagestellung durch von den Seitenwänden nach innen vorstehende angespritzte Federzungen fixiert sein.

Um das Leiterplattenpaket selbst auf einfache Weise herstellen zu können, ist vorgesehen, daß die Ausnehmungen in den Leiterplatten zum Leiterplattenrand hin offen und mit Einführungsschrägflächen versehen sind.

Wenn die Ausnehmungen einen Durchmesser aufweisen, der etwas geringer ist als der Durchmesser der Hülsen oder von Nuten an den Hülsen, halten die Abstandselemente die Leiterplatten durch eine Schnapp-/Rastverbindung zusammen

Von der der Gehäuserückwandseite zugewandten Rückseite der hinteren Leiterplatte stehen Anschlußelemente in Form von Steckerleisten, Schraubklemmleisten und dgl. ab. Die Anschlußelemente tauchen in Endmontagestellung des Leiterplattenpakets in zugeordnete Führungsausnehmungen des Gehäuserückteils ein und sind auf diese Weise ausreichend gegen mechanische Belastungen beim Zug von Kabeln oder Steckern oder auch beim Einstecken der Stecker geschützt.

Die Führungsausnehmungen des Gehäuserückteils weisen Öffnungen auf, die bezogen auf die eingeführten Anschlußelemente derart ausgebildet sind, daß in den Anschlußelementen befindliche Steck-, Klemm- oder Schraubelemente von der Gehäuseaußenseite her zugänglich sind, so daß das Anschließen von Kabeln, Leitern oder das Einstecken von Steckern bei geschlossenem Gehäuse vollzogen werden kann.

Das Gehäuserückteil weist ferner eine rucksackartige Ausbuchtung auf. Die Öffnungen der Führungsausnehmungen sind im Bereich einer Stufe des Gehäuserückteils angeordnet, so daß in die Anschlußelemente eingesteckte Stecker und der dgl. durch die rucksackartige Ausbuchtung geschützt sind.

Die Erfindung/Neuerung ist anhand von Ausführungsbeispielen in den Zeichnungsfiguren näher erläutert. Diese zeigen:

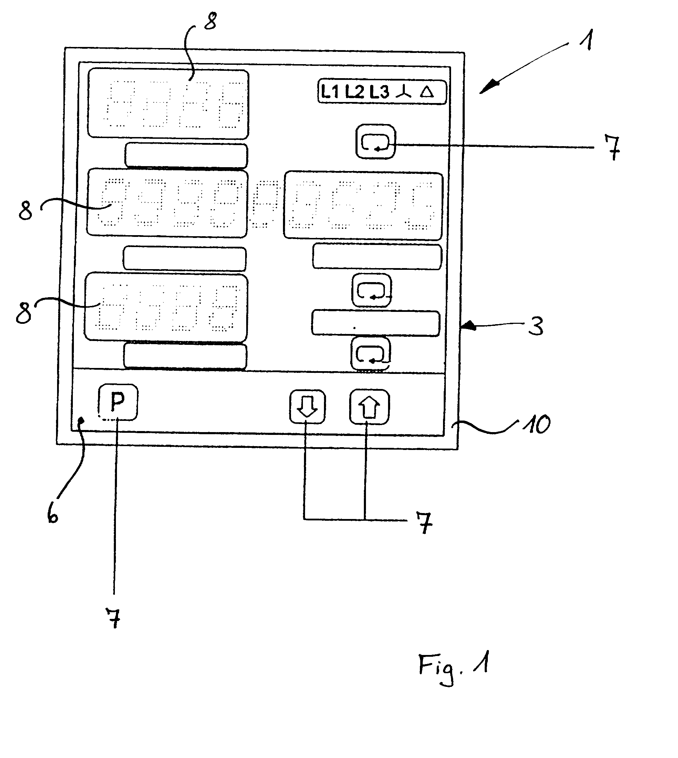

- Fig. 1: eine perspektivische Darstellung der Frontseite des Gerätes;

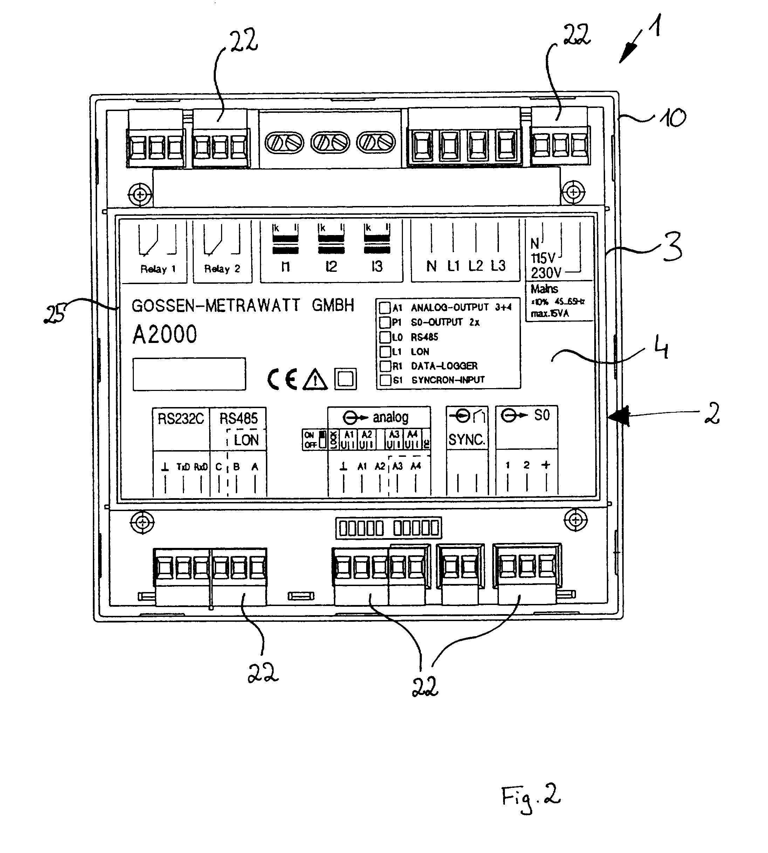

- Fig. 2: eine perspektivische Darstellung der Rückseite des Gerätes, wobei an das Gerät Anschlußstecker angesetzt sind;

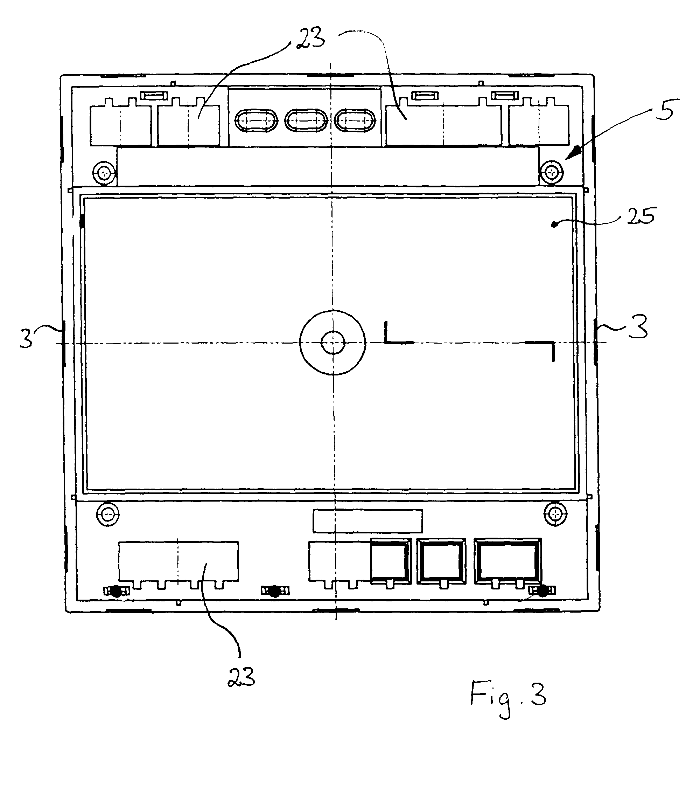

- Fig. 3: eine Rückansicht des Gehäuserückteils;

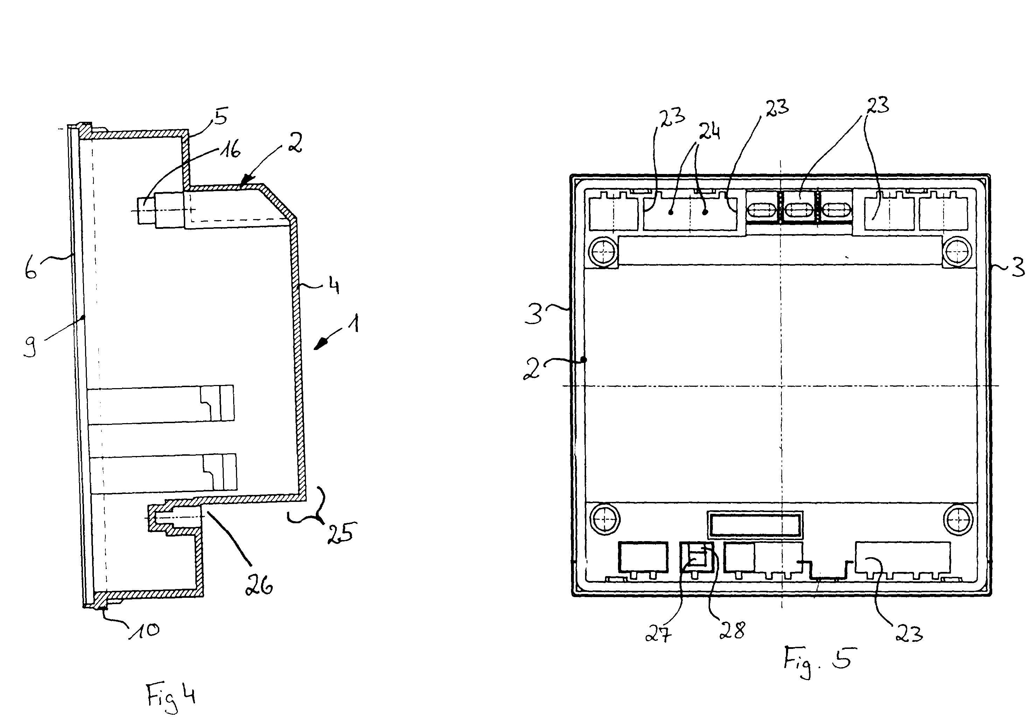

- Fig. 4: einen Schnitt durch das Gehäuserückteil,
- Fig. 5: eine Einsicht von der Frontseite in das Gehäuserückteil sowie

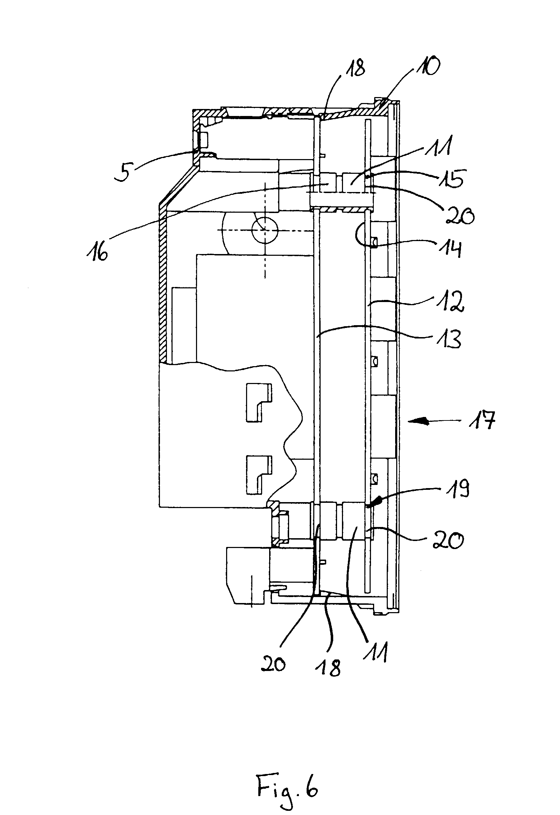

- Fig. 6: einen Schnitt durch das Gerät mit eingesetzten Leiterplatten.

Das elektronische Gerät 1 weist ein Einbaugehäuse 2 auf, das ein Seitenwände 3 und eine Rückwand 4 bildendes Gehäuserückteil 5 hat und eine Gehäusefront 6 umfaßt, in welcher Bedienungs- 7 und Anzeigeelemente 8 vorgesehen sind. Die Anzeigeelemente 8 werden von einer Abdeckscheibe 9 überdeckt, die von einem Rahmen 10 gehalten wird.

Parallel und mit geringem Abstand hinter der Gehäusefront 6 ist ein Paket aus zwei über Abstandselemente 11 als Sandwich miteinander verbundenen Leiterplatten 12, 13 befestigt, die den lichten Querschnitt des Gehäuserückteils 5 ausfüllen und als Träger für die Bedienungs- 7 und Anzeigeelemente 8 und elektronische Bauteile dienen.

Die beiden Leiterplatten 12, 13 sind quadratisch und liegen deckungsgleich übereinander Sie sind an ihren Rändern 14 mit miteinander fluchtenden Ausnehmungen 15 versehen, in welchen die Abstandselemente 11 befestigt sind. Die Abstandselemente 11 sind Hülsen und haben einen runden Querschnitt. Das Paket aus den beiden zusammengefügten Leiterplatten 12, 13 ist von der Gehäusefront 6 her in das Gehäuserückteil 5 einschiebbar. Dabei übergreifen die als Hülsen ausgebildeten Abstandselemente 11 Führungszapfen 16, die in Einschubrichtung 17 (Pfeilrichtung) von der Gehäuserückwand oder einem Randbereich derselben abstehen.

Das Paket aus den beiden Leiterplatten 12, 13 wird in Endmontagestellung durch von den Seitenwänden 3 nach innen vorstehende angespritzte Federzungen 18 fixiert.

Die Ausnehmungen 15 in den Rändern 14 der beiden Leiterplatten 12, 13 sind zu den Rändern 14 hin offen und mit Einführungsschrägflächen 19 versehen, um die als Hülsen ausgebildeten Abstandselemente 11 mit in ihnen vorgesehenen Nuten 20 in die Ausnehmungen 15 im Sinne einer Schnapp/Rastverbindung einklipsen zu können.

Auf der der Gehäuserückseite zugewandten Rückseite 21 der hinteren Leiterplatte 13 sind Anschlußelemente 22 in Form von Stecker- oder Klemmleisten angeordnet, die in Endmontagestellung in zugeordnete Führungsausnehmungen 23 des Gehäuserückteils 5 eintauchen und dort gegen Verbiegen oder Ausreißen aus der Leiterplatte 13 fixiert sind. Die Führungsausnehmungen 23 weisen Öffnungen 24 auf, die bezogen auf die eingeführten Anschlußelemente 22 derart ausgebildet sind, daß in den Anschlußelementen 22 befindliche Klemm- oder Schraubelemente von der Gehäuseaußenseite her zugänglich sind, so daß Leiter in den Anschlußelementen verschraubt werden können

Das Gehäuserückteil 5 ist mit einer rucksackartigen Ausbuchtung 25 versehen. Die Öffnungen 24 der Führungsausnehmungen 23 sind im Bereich einer Stufe 26 des Gehäuserückteils 5 angeordnet, die die rucksackartige Ausbuchtung 25 vom Rest des Gehäuserückteils 5 absetzt.

Ferner sind im Gehäuserückteil 5 Gehäusewandbereiche 27 angeordnet, die mit dem Gehäuserückteil 5 durch Sollbruchstellen 28 verbunden sind und zur Bildung von weiteren Anschluß- oder Einstecköffnungen aus dem Gehäuserückteil 5 ausgebrochen werden können.

### BEZUGSZEICHEN

- 1: Gerät
- 2: Einbaugehäuse
- 3: Seitenwand
- 4: Rückwand
- 5: Gehäuserückteil
- 6: Gehäusefront
- 7: Bedienungselement
- 8: Anzeigeelement
- 9: Abdeckscheibe
- 10: Rahmen
- 11: Abstandselement
- 12: Leiterplatte
- 13: Leiterplatte
- 14: Ränder von 12 und 13
- 15: Ausnehmung
- 16: Führungszapfen
- 17: Einschubrichtung
- 18: Federzunge
- 19: Einführungsschrägfläche
- 20: Nut
- 21: Rückseite von 13
- 22: Anschlußelement
- 23: Führungsausnehmung
- 24: Öffnung
- 25: Ausbuchtung
- 26: Stufe
- 27: Gehäusewandbereich
- 28: Sollbruchstelle

## Patentansprüche

1. Elektronisches Gerät (1) mit einem Einbaugehäuse (2) zum Einsetzen in ein Wandelement, insbesondere eine Schalttafel, einen Schaltschrank oder dgl., wobei das Einbaugehäuse (2) aus einem seiten- und rückwandbildenden Gehäuserückteil (5) sowie einer Gehäusefront (6) besteht, in welcher Bedienungs- und/oder Anzeigeelemente angeordnet sind und die mit einer Abdeckscheibe versehen ist,
**dadurch gekennzeichnet, daß** parallel und mit geringem Abstand hinter der Gehäusefront (6) oder der Abdeckscheibe ein Paket aus mindestens zwei über Abstandselemente (11) als Sandwich miteinander verbundenen Leiterplatten (12, 13) befestigt ist, die den lichten Querschnitt des Gehäuserückteils (5) ausfüllen und als Träger für die Bedienungs- (7) und Anzeigeelemente (8) und elektronische Bauteile dienen.

2. Elektronisches Gerät nach Anspruch 1,
**dadurch gekennzeichnet, daß** die Leiterplatten (12, 13) im wesentlichen deckungsgleich übereinander liegen.

3. Elektronisches Gerät nach Anspruch 1 oder 2,
**dadurch gekennzeichnet, daß** die Leiterplatten (12, 13) an ihren Rändern (14) mit miteinander fluchtenden Ausnehmungen (15) versehen sind, in welchen die Abstandselemente (11) befestigt sind.

4. Elektronisches Gerät nach einem der vorhergehenden Ansprüche,
**dadurch gekennzeichnet, daß** die Abstandselemente (11) Hülsen sind.

5. Elektronisches Gerät nach einem der vorhergehenden Ansprüche,
**dadurch gekennzeichnet, daß** die Abstandselemente (11) einen runden Querschnitt aufweisen.

6. Elektronisches Gerät nach einem der vorhergehenden Ansprüche,
**dadurch gekennzeichnet, daß** das Paket aus Leiterplatten (12, 13) von der Gehäusefront (6) in das Gehäuserückteil (5) einschiebbar ist.

7. Elektronisches Gerät nach Anspruch 6,
**dadurch gekennzeichnet, daß** die als Hülsen ausgebildeten Abstandselemente (11) Führungszapfen (16) übergreifen, die in Einschubrichtung (17) von der Gehäuserückwand (4) abstehen.

8. Elektronisches Gerät nach einem der vorhergehenden Ansprüche 6 oder 7,
**dadurch gekennzeichnet, daß** das Paket der Leiterplatten (12, 13) in Endmontagestellung durch von den Seitenwänden (3) nach innen vorstehende angespritzte Federzungen (18) fixiert ist.

9. Elektronisches Gerät nach einem der vorhergehenden Ansprüche,
**dadurch gekennzeichnet, daß** die Ausnehmungen (15) in den Leiterplatten (12, 13) zum Leiterplattenrand (14) hin offen und mit Einführungsschrägflächen (19) versehen sind.

10. Elektronisches Gerät nach einem der vorhergehenden Ansprüche,
**dadurch gekennzeichnet, daß** die Abstandselemente (11) in ihren Endbereichen Nuten (20) aufweisen, deren Breite der Stärke der Leiterplatten (12, 13) entspricht und in denen die Ausnehmungen (11) durch eine Schnapp-/Rastverbindung gehalten sind.

11. Elektronisches Gerät nach einem der vorhergehenden Ansprüche,
**dadurch gekennzeichnet, daß** auf der der Gehäuserückseite zugewandten Rückseite (21) der hinteren Leiterplatte (13) Anschlußelemente (22) (Steckerleisten, Klemmleisten) angeordnet sind.

12. Elektronisches Gerät nach Anspruch 11,
**dadurch gekennzeichnet, daß** die Anschlußelemente (22) in Endmontagestellung in zugeordnete Führungsausnehmungen (23) des Gehäuserückteils (5) eintauchen.

13. Elektronisches Gerät nach einem der vorhergehenden Ansprüche,
**dadurch gekennzeichnet, daß** die Führungsausnehmungen (23) Öffnungen (24) aufweisen, die bezogen auf die eingeführten Anschlußelemente (22) derart ausgebildet sind, daß in den Anschlußelementen (22) befindliche Steck-, Klemm- oder Schraubelemente von der Gehäuseaußenseite her zugänglich sind.

14. Elektronisches Gerät nach einem der vorhergehenden Ansprüche,
**dadurch gekennzeichnet, daß** das Gehäuserückteil (5) mit einer rucksackartigen Ausbuchtung (25) versehen ist und die Öffnungen (24) der Führungsausnehmungen (23) im Bereich einer Stufe des Gehäuserückteils (5) angeordnet sind.

15. Elektronisches Gerät nach einem der vorhergehenden Ansprüche,
**dadurch gekennzeichnet, daß** in dem Gehäuserückteil (5) Gehäusewandbereiche (27) angeordnet sind, die mit dem Gehäuserückteil (5) durch Sollbruchstellen (28) verbunden und zur Bildung von weiteren Anschluß- oder Einstecköffnungen aus dem Gehäuserückteil (5) ausbrechbar sind.
